(19) Europäisches Patentamt
European Patent Office
Office européen des brevets

(11) **EP 3 846 198 A1**

(12) **EUROPEAN PATENT APPLICATION**
published in accordance with Art. 153(4) EPC

(43) Date of publication:
**07.07.2021 Bulletin 2021/27**

(51) Int Cl.:
**H01L 21/02** *(2006.01)*     **H01L 21/677** *(2006.01)*

(21) Application number: **19855613.6**

(22) Date of filing: **23.08.2019**

(86) International application number:
**PCT/JP2019/033077**

(87) International publication number:
**WO 2020/045286 (05.03.2020 Gazette 2020/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(30) Priority: **30.08.2018   JP 2018161562**

(71) Applicant: **CREATIVE TECHNOLOGY CORPORATION**
**Kawasaki-shi, Kanagawa 213-0034 (JP)**

(72) Inventors:
• **TATSUMI, Yoshiaki**
  **Kawasaki-shi, Kanagawa 213-0034 (JP)**
• **HIRANO, Shinsuke**
  **Kawasaki-shi, Kanagawa 213-0034 (JP)**
• **TAHARA, Kazuaki**
  **Kawasaki-shi, Kanagawa 213-0034 (JP)**

(74) Representative: **Vossius & Partner**
**Patentanwälte Rechtsanwälte mbB**
**Siebertstrasse 3**
**81675 München (DE)**

(54) **CLEANING DEVICE**

(57)    Provided is a cleaning device that can prevent reduction of an electrostatic clamping force in a vacuum state and can remove foreign matter in a vacuum processing chamber of a semiconductor manufacturing apparatus. The cleaning device includes: a foreign matter attraction unit 4 in which attraction electrodes 3 composed of a pair of electrodes are provided inside an insulator; and an attraction control unit 5 that turns on a control switch to charge the attraction electrodes and generate an electrostatic clamping force on a surface of the insulator to enable attraction of foreign matter, wherein the control switch of the attraction control unit 5 is a remotely-operable switch that is externally operable, and foreign matter in the vacuum processing chamber can be removed by an electrostatic clamping force generated in a vacuum state by turning on the control switch for the cleaning device in a vacuum closed space closed in the vacuum state.

Fig. 2

EP 3 846 198 A1

**Description**

[Technical Field]

The present invention relates to a cleaning device for removing foreign matter in a vacuum processing chamber of a semiconductor manufacturing apparatus, and more specifically to a cleaning device in which attraction electrodes are provided inside an insulator and which can attract and remove foreign matter by electrostatic attraction.

[Background Art]

For example, various types of foreign matter generated in a semiconductor manufacturing process adhere to or float in a vacuum processing chamber of a semiconductor manufacturing apparatus used in various semiconductor manufacturing processes, such as an ion implantation apparatus, an etching apparatus, a CVD apparatus, and a lithography apparatus. Examples of such foreign matter include fragments from silicon wafers, resist residues, dust and dirt derived from components in the vacuum processing chamber generated by plasma and mechanical friction, and other particles brought in from the outside by transporting a wafer (in the present description, these are collectively referred to as foreign matter).

A problem arising when such foreign matter is deposited in the vacuum processing chamber is that, for example, when an electrostatic chuck for attracting and fixing an object to be processed such as a silicon wafer is used, the foreign matter penetrates between the attraction surface of the electrostatic chuck and the object to be processed, the contact between the electrostatic chuck and the object to be processed becomes insufficient, and the cooling performance of the object to be processed by the electrostatic chuck deteriorates. Yet another problem is that the presence of foreign matter on the back surface side of the object to be processed causes deviation in position accuracy of the object to be processed, and for example, in a lithography apparatus, a focal length mismatch may occur. Further, the foreign matter adheres to the surface (main surface) side of the object to be processed, which may cause a problem such as wiring failure.

For this reason, semiconductor manufacturing apparatuses are regularly cleaned to remove foreign matter in the vacuum processing chamber and prevent foreign matter from accumulating. However, such cleaning is mainly manual work, and therefore the possibility of causing new artificial contamination cannot be ruled out. In addition, manual cleaning is uneconomical because it is necessary to release vacuum in the vacuum processing chamber at the time of cleaning, and it takes several hours each time to obtain the required vacuum degree when restarting the semiconductor manufacturing apparatus.

Accordingly, some cleaning devices have been proposed for removing foreign matter without releasing the vacuum in the vacuum processing chamber. For example, PTL 1 discloses a dust attracting wafer in which a dummy wafer charged by corona charging or the like is conveyed into a vacuum processing chamber of a semiconductor manufacturing apparatus, and dust (foreign matter) is attracted by the electrostatic force of the dummy wafer. Further, PTL 2 discloses a cleaning device in which a cleaning sheet such as polyethylene terephthalate electrically polarized by electrically electreting by a corona method or thermally electreting is attached to a cleaning wafer and conveyed to a vacuum processing chamber of a semiconductor manufacturing apparatus to remove foreign matter. Further, PTL 3 discloses a cleaning device in which a cleaning wafer made of a pressure-sensitive adhesive polymer is placed on a wafer stage of a semiconductor manufacturing apparatus with protrusions being interposed therebetween, and foreign matter on the wafer stage is collected by the pressure-sensitive adhesive cleaning wafer when the protrusions are compressed and crushed.

However, where the conventional cleaning device uses a pressure-sensitive adhesive cleaning polymer, it is necessary to replace the pressure-sensitive adhesive each time it is used, which increases running costs. Meanwhile, where a dummy wafer is charged by corona charging or the like, it becomes necessary to incorporate equipment for charging into the existing equipment.

[Citation List]

[Patent Literature]

[PTL 1] Japanese Patent Application Publication No. 2000-260671
[PTL 2] Japanese Patent Application Publication No. 2002-28594
[PTL 3] Japanese Patent No. 5956637

[Summary of Invention]

[Technical Problem]

The present inventors have studied a cleaning device that charges the surface to electrostatically attract and remove foreign matter in a vacuum processing chamber, and the obtained experimental results have shown that the electrostatic clamping force obtained by charging under the atmospheric pressure is dramatically reduced when the device is brought into vacuum. That is, it is conceivable that where a dummy wafer or the like that exhibits an electrostatic clamping force under the atmospheric pressure is transported to a vacuum processing chamber, as in the conventional cleaning device, sufficient attraction performance of foreign matter in the vacuum processing chamber actually will not be demonstrated.

Therefore, as a result of further studies, the present inventors have found that the effectiveness of attraction of foreign matter in the vacuum processing chamber can be enhanced by using a remotely-operable control switch, which is operable from the outside, to make it possible to charge the cleaning device in a vacuum state and develop an electrostatic clamping force, and have thus arrived at the present invention.

Therefore, an object of the present invention is to provide a cleaning device capable of removing foreign matter in a vacuum processing chamber while suppressing a decrease in electrostatic clamping force.

[Solution to Problem]

That is, the present invention provides a cleaning device for removing foreign matter in a vacuum processing chamber of a semiconductor manufacturing apparatus, the cleaning device including: a foreign matter attraction unit in which attraction electrodes composed of a pair of electrodes are provided inside an insulator; and an attraction control unit that turns on a control switch to charge the attraction electrodes and generate an electrostatic clamping force on the surface of the insulator to enable attraction of foreign matter, wherein the control switch of the attraction control unit is a remotely-operable switch that is operable externally, and foreign matter in the vacuum processing chamber can be removed by an electrostatic clamping force generated in a vacuum state by turning on the control switch for the cleaning device in a vacuum closed space closed in the vacuum state.

The cleaning device of the present invention includes the foreign matter attraction unit in which the attraction electrodes composed of a pair of electrodes are provided inside the insulator, and the attraction control unit that turns on the control switch to charge the attraction electrodes and generate an electrostatic clamping force on the surface of the insulator to enable attraction of foreign matter, wherein a remotely-operable switch that is externally operable is used as the control switch of the attraction control unit.

This remotely-operable control switch is externally operable, and a control switch that can turn on the circuit contacts of the attraction control unit of a cleaning device in a vacuum closed space that is closed in a vacuum state while keeping a vacuum state without cutting the vacuum (that is, a switch that can control the electrical connection wirelessly without having a reed wire) may be used, examples thereof including a timer-type switch that has a built-in timer and turns on/off after a lapse of predetermined time, a laser-sensing switch that operates by sensing an external laser beam, a reed switch that operates by magnetic force, a combination of two or more thereof, and combinations of these switches with other switches.

Here, a vacuum processing chamber of a semiconductor manufacturing apparatus from which foreign matter is to be removed corresponds to the vacuum closed space that is closed in the vacuum state, another example of such state being a space provided together with the vacuum processing chamber, such as an intermediate transfer chamber or the like for supplying an object to be processed such as a silicon wafer by a transfer robot.

Further, the attraction control unit may have a built-in power supply for charging the attraction electrodes of the foreign matter attraction unit and developing an electrostatic clamping force on the surface of the insulator, or may have a built-in power storage element capable of storing electric energy, e.g. by temporarily storing an electric charge in a capacitor or the like by using an external power supply, without incorporating a power supply.

Of these, in the case where a power supply is built in, for example, the attraction control unit may include a booster circuit that boosts the voltage, a battery for operating the booster circuit, and a voltage application switch for charging the attraction electrodes with a high voltage output from the booster circuit, and remotely-operable control switch may be configured by the voltage application switch. With such a configuration, where the cleaning device is arranged in the vacuum closed space and the voltage application switch is turned on, the electrostatic clamping force can be exhibited in the vacuum state. At that time, a diode may be provided between the booster circuit and the attraction electrodes. As a result, the charging of the attraction electrodes due to the high voltage output from the booster circuit is maintained by the rectifying action, so that it is not necessary to always maintain the output of the booster circuit.

Meanwhile, when the power supply is not built in, for example, the attraction control unit may include a connection terminal for connection with an external power supply, a capacitor that is charged by a voltage of the external power supply connected to the connection terminal and that stores the electric charge, and a discharge switch that discharges the charge stored in the capacitor to charge the attraction electrodes, and the aforementioned remotely-operable control switch may be configured by the discharge switch. With such a configuration, once the capacitor is charged by connection to the external power supply under the atmospheric pressure and then the cleaning device is placed in a vacuum closed space and the discharge switch is turned on, an electrostatic clamping force can be demonstrated in a vacuum state. Further, by incorporating a power storage element such as a capacitor instead of incorporating a power supply, the attraction control unit can be made smaller, which is convenient in that, for example, the cleaning device itself can be more reliably sealed.

Further, the attraction control unit may be provided with a GND terminal for releasing the charge of the charged attraction electrodes, and a GND switch for connecting the attraction electrodes and the GND terminal. By attracting the foreign matter in the vacuum processing chamber and then turning on the GND switch to release the electric charge from the GND terminal, it is possible to remove the foreign matter easily from the surface of the insulator of the foreign matter attraction unit.

Here, the foreign matter may be removed from the surface of the insulator of the foreign matter attraction unit after the cleaning device is carried out from the vacuum processing chamber of the semiconductor manufacturing apparatus. For example, the cleaning apparatus may be moved to the intermediate transfer chamber and the GND switch may be turned on while maintaining the vacuum to allow the charge to escape from the GND terminal, or the cleaning device may be carried out from the intermediate transfer chamber and the GND switch may be turned on in the atmosphere. In order to enable the GND switch to be turned on under vacuum, the GND switch may also be configured by a remotely-operable switch that is externally operable as described above.

Further, the foreign matter attraction unit of the cleaning device of the present invention may be such that the attraction electrodes composed of a pair of electrodes are provided inside an insulator to enable the attraction of foreign matter in the vacuum processing chamber of the semiconductor manufacturing apparatus by an electrostatic clamping force generated on the surface of the insulator. Here, in order to deal with both positively charged foreign matter and negatively charged foreign matter in the vacuum processing chamber, the attraction electrodes are made up of a pair of electrodes so that one is charged positively and the other is charged negatively.

The shape and size of the foreign matter attraction unit are not particularly limited, but it is desirable that the foreign matter attraction unit be compatible with the shape of the object to be processed such as a wafer or a glass substrate handled by the semiconductor manufacturing apparatus from which the foreign matter is to be removed. Further, the material and forming means thereof are not particularly limited as well, and for example, an attraction electrode of a predetermined shape formed of a metal foil may be sandwiched between two resin films made of a polyimide, polyethylene terephthalate (PET), a fluororesin or the like, and a foreign matter attraction unit may be formed by a resin insulator in which such configurations are laminated, or a foreign matter attraction unit may be formed by a ceramic insulator obtained by forming a metal layer on one of the two green sheets so as to obtain an attraction electrode of a predetermined shape, laminating such configurations and firing, or a foreign matter attraction unit may be formed by other method or material.

Further, in the cleaning device of the present invention, the foreign matter attraction unit and the attraction control unit may be provided integrally with the base portion having a shape imitating an object to be processed in a semiconductor manufacturing apparatus, such as a wafer or a glass substrate. As a result, the cleaning device can be easily carried into the vacuum processing chamber by using means and route for carrying the object to be processed. At that time, the foreign matter on a wafer mounting table can be effectively removed by arranging the foreign matter attraction unit on the back surface of the base portion so that the surface of the insulator of the foreign matter attraction unit faces the wafer mounting table side in the vacuum processing chamber. Further, foreign matter that floats in the processing space in the vacuum processing chamber can be removed by arranging the foreign matter attraction unit on the surface of the base portion so that the surface of the insulator of the foreign matter attraction unit faces the processing space side of the vacuum processing chamber opposite to the wafer mounting side.

Here, when the foreign matter attraction unit is arranged on the back surface of the base portion so that the surface of the insulator of the foreign matter attraction unit faces the wafer mounting table side in the vacuum processing chamber, a protrusion may be provided to separate the surface of the insulator in the foreign matter attraction unit and the wafer mounting table. As a result, the risk of the foreign matter being caught and crushed between the insulator of the foreign matter attraction unit and the wafer mounting table, and of the surface of the attraction unit or the wafer mounting table being damaged by the foreign matter can be eliminated.

Further, after providing such a protrusion, an adhesive layer having adhesiveness may be provided on the surface of the insulator of the foreign matter attraction portion. As a result, the once attracted foreign matter can be more reliably captured, and the risk of recontamination by the attracted foreign matter, for example, occurring when the foreign matter falls down during the transportation of the cleaning device, can be eliminated. Here, the adhesive layer can be formed, for example, by coating a high-purity siliconebased adhesive or the like, but a layer that is unlikely to generate any gas in the vacuum processing chamber (a layer having a small amount of degas) is desirable.

The semiconductor manufacturing apparatus from which foreign matter is to be removed is not particularly limited, and the present invention is suitable for any semiconductor manufacturing apparatus including a vacuum processing chamber for processing the object to be processed under vacuum in a semiconductor manufacturing process, but preferred among them is an apparatus using an electrostatic chuck that attracts and holds the object to be processed by an electrostatic clamping force. Examples of such a semiconductor manufacturing apparatus include an ion implantation apparatus, an ion doping apparatus, an etching apparatus, a CVD apparatus, an ashing apparatus, a stepper apparatus, a lithography apparatus, a liquid crystal substrate manufacturing apparatus, and a wafer inspection apparatus. Further, as described at the beginning of the description, various types of foreign matter in the vacuum processing chamber that were generated or admixed in the semiconductor manufacturing process are the objects to be removed.

[Advantageous Effects of Invention]

With the cleaning device of the present invention, the cleaning device in a vacuum state can be charged to generate an electrostatic clamping force by using a remotely-operable control switch that is operable from the outside. Therefore, foreign matter in the vacuum processing chamber can be removed with improved effectiveness without problems such dramatic reduction in the electrostatic clamping force generated under the atmospheric pressure.

[Brief Description of Drawings]

[Fig. 1]

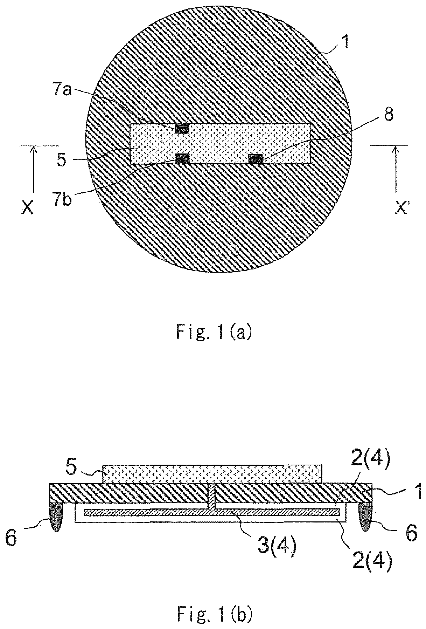

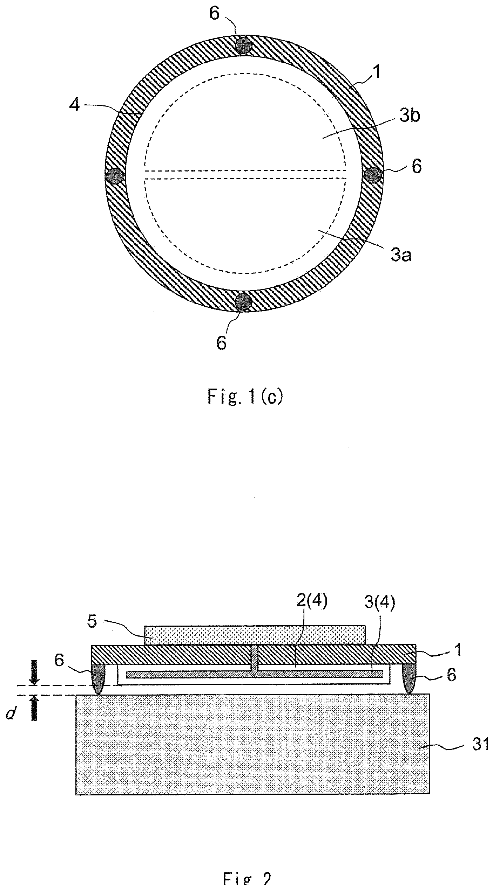

Fig. 1 is an explanatory view of a cleaning device according to the present invention, Fig. 1(a) shows a plan view (surface), Fig. 1(b) shows a cross-sectional view (X-X'), and Fig. 1(c) shows a plan view (back surface).
[Fig. 2]
Fig. 2 is an explanatory view showing a usage mode of the cleaning device in a vacuum processing chamber.
[Fig. 3]

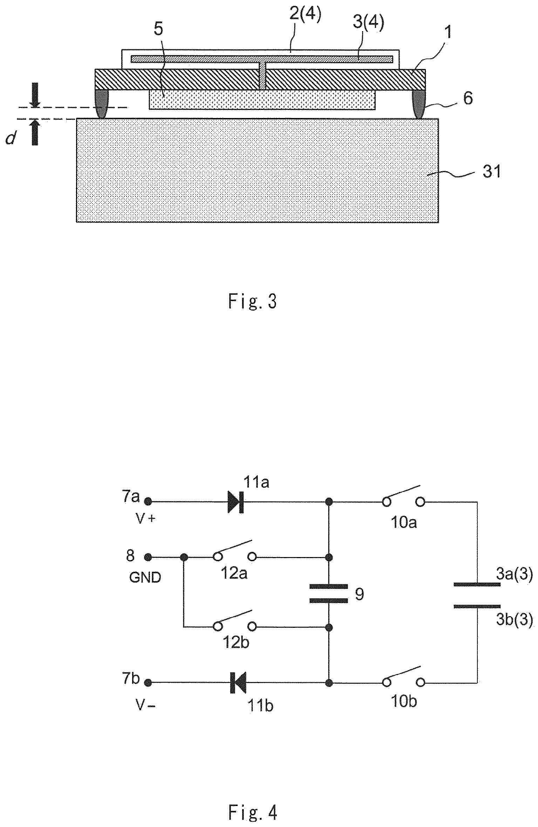

Fig. 3 is an explanatory view showing a usage mode based on a modified example of the cleaning device.
[Fig. 4]
Fig. 4 is an explanatory view showing a first example of an attraction control circuit forming an attraction control unit.
[Fig. 5]

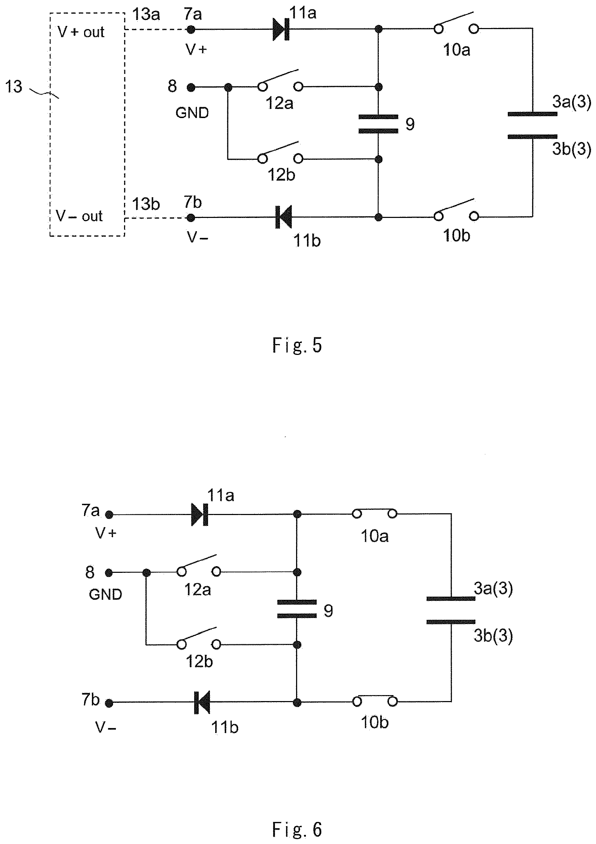

Fig. 5 is an explanatory view showing a state in which an external power supply is connected to the attraction control circuit of the first example to charge a capacitor.
[Fig. 6]
Fig. 6 is an explanatory view showing a state in which the capacitor is discharged to charge the attraction electrodes in the attraction control circuit of the first example.
[Fig. 7]

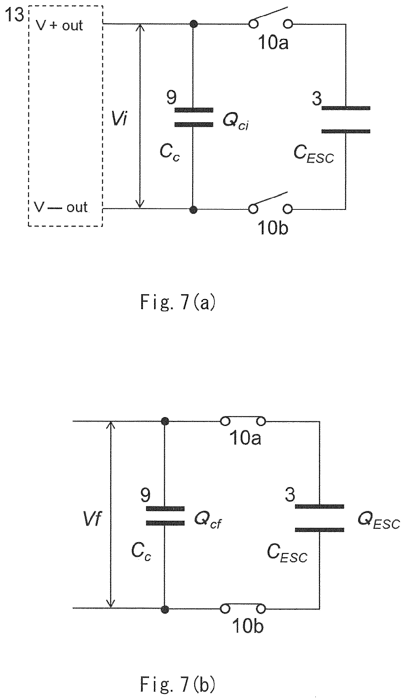

Fig. 7 is an explanatory view illustrating the calculation of charge transfer from the capacitor to the attraction electrode, Fig. 7(a) shows a state in which an external power supply is connected, and Fig. 7(b) shows a state in which the external power supply is disconnected and the capacitor and the attraction electrodes are connected.
[Fig. 8]

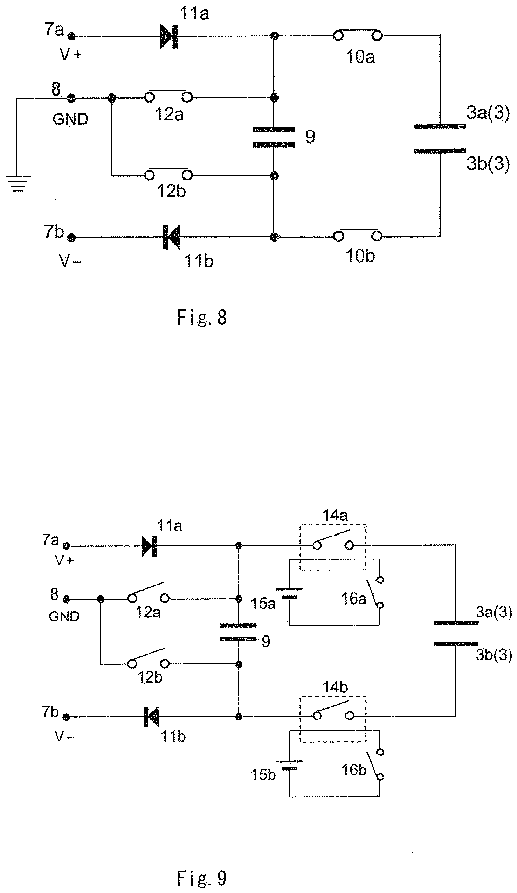

Fig. 8 is an explanatory view showing a state in which a GND terminal is connected to GND and the charge of the attraction electrodes is released in the attraction control circuit of the first example.
[Fig. 9]
Fig. 9 is an explanatory view showing a second example of an attraction control circuit forming an attraction control unit.
[Fig. 10]

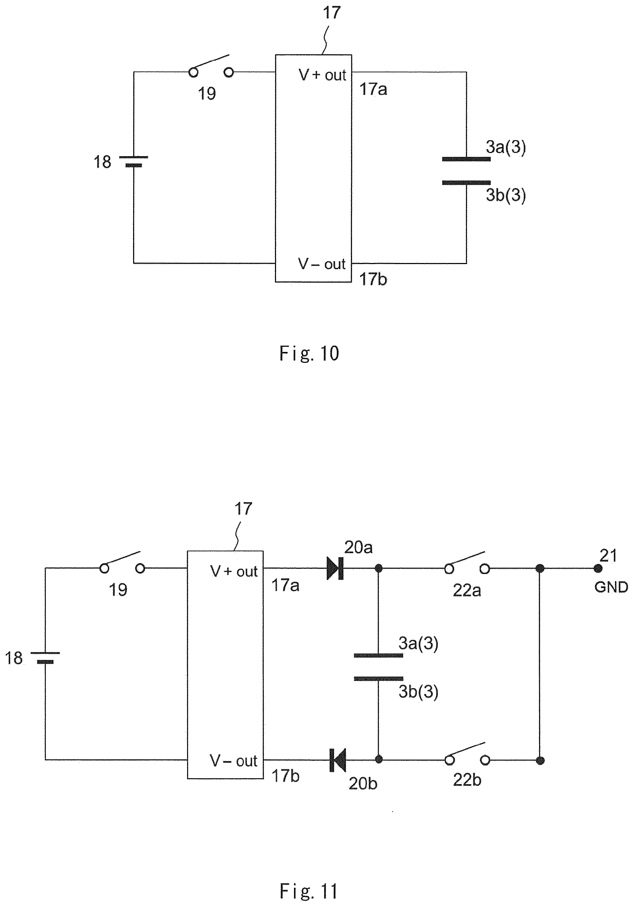

Fig. 10 is an explanatory view showing a third example of an attraction control circuit forming an attraction control unit.
[Fig. 11]
Fig. 11 is an explanatory view showing a fourth example of an attraction control circuit forming an attraction control unit.
[Fig. 12]

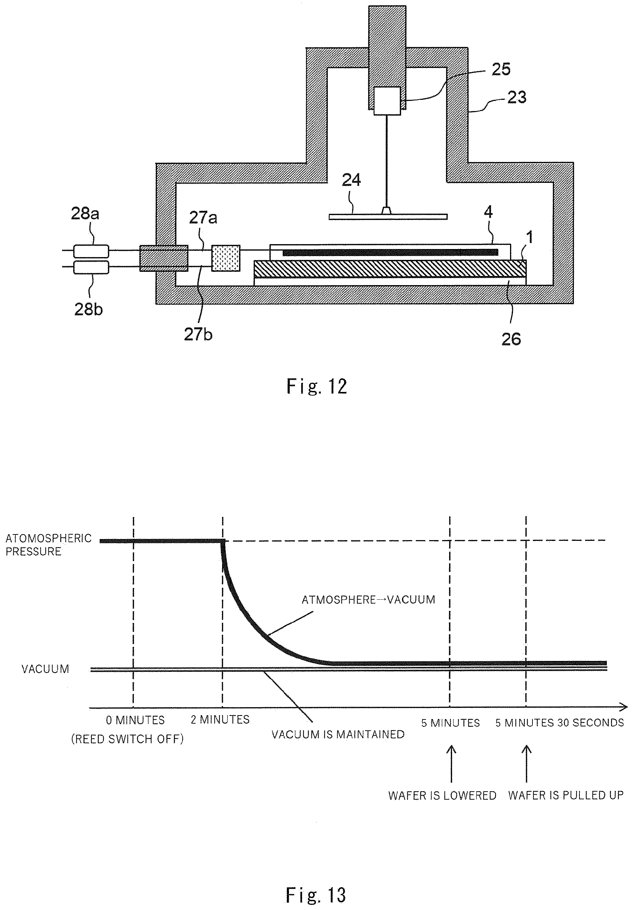

Fig. 12 is a schematic view for explaining the test apparatus used in Test Example 1.
[Fig. 13]
Fig. 13 is a schematic view for explaining the outline of measurement conditions and pressure conditions in Test Example 1.
[Fig. 14]

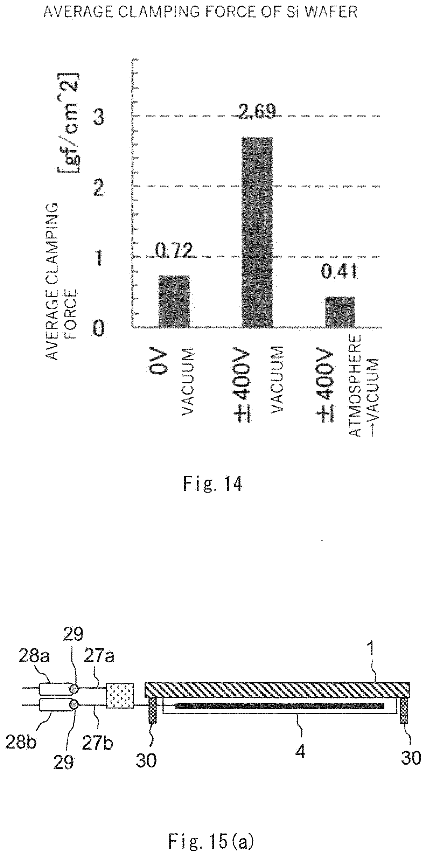

Fig. 14 is a graph showing the measurement result of the clamping force in Test Example 1.
[Fig. 15]

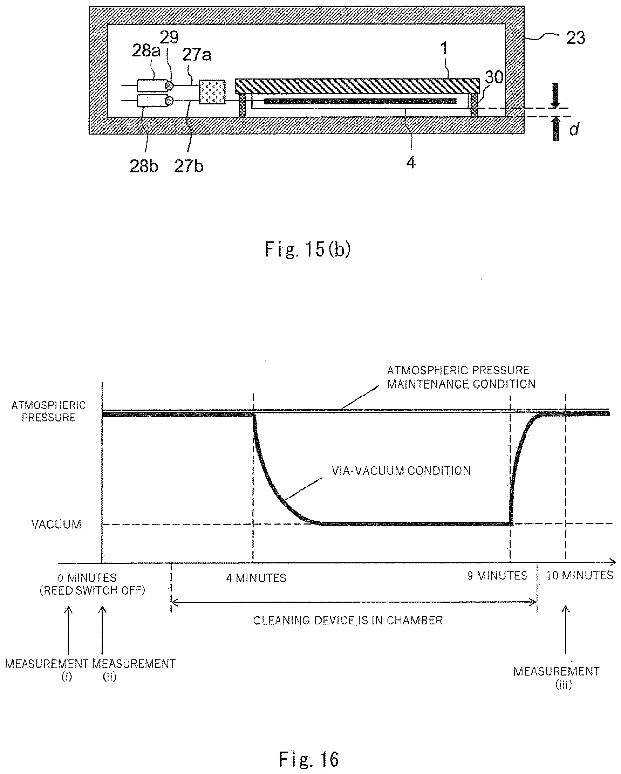

Fig. 15 is a schematic view for explaining the test apparatus used in Test Example 2.

[Fig. 16]

Fig. 16 is a schematic view for explaining an outline of measurement conditions and pressure conditions in Test Example 2.

[Fig. 17]

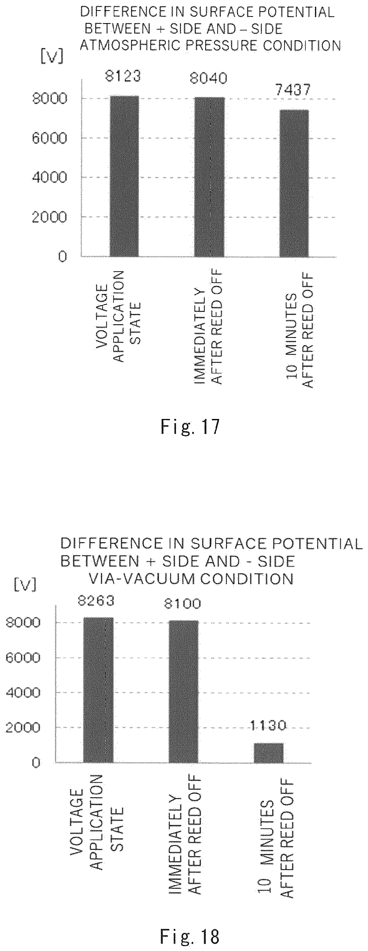

Fig. 17 is a graph showing the measurement result of the surface potential in Test Example 2 (in the case of atmospheric pressure maintenance condition).

[Fig. 18]

Fig. 18 is a graph showing the measurement results of the surface potential in Test Example 2 (in the case of via-vacuum condition).

[Description of Embodiments]

Hereinafter, the present invention will be described in more detail.

Fig. 1 shows an example of a cleaning device according to the present invention. As shown in the cross-sectional view of Fig. 1(b), this cleaning device is provided with a foreign matter attraction unit 4 on one surface (back surface) and with an attraction control unit 5 on the other surface (surface) of a disc-shaped base portion 1 made of a silicon wafer, alumina, or the like. Further, on the back surface of the base portion 1, four protrusions 6 are provided on the outside of the foreign matter attraction unit 4 at positions that divide the base portion 1 into four substantially equal parts in the circumferential direction.

Of these, in the foreign matter attraction unit 4, a pair of semicircular attraction electrodes 3a and 3b made of copper foil are interposed between two circular polyimide films 2 that are bonded to each other to form an insulator, as shown in the cross-sectional view of Fig. 1(b) and the plan view (back surface) of Fig. 1(c). Further, the attraction control unit 5 has an attraction control circuit that charges these attraction electrodes 3a and 3b to generate an electrostatic clamping force, and includes, as shown in the plan view of Fig. 1(a) (back surface of the attraction control unit 5), input terminals 7a and 7b serving as connection terminals for connection with an external power supply, which will be described later, and a GND terminal 8 for releasing the charges of the charged attraction electrodes 3a and 3b. The foreign matter attraction unit 4 and the attraction control unit 5 are bonded to the base portion 1 by respective bonding sheets. Although the semicircular attraction electrodes 3a and 3b are shown in Fig. 1, the shapes of the attraction electrodes 3a and 3b are not limited thereto, and for example, comb tooth type attraction electrodes 3a and 3b or the like may be used.

Further, Fig. 2 shows a usage mode of the cleaning device according to Fig. 1 in the vacuum processing chamber. Thus, the foreign matter on the wafer mounting table can be removed by arranging the surface of the insulator (the surface of the polyimide film 2) forming the foreign matter attraction unit 4 so as to face a wafer mounting table 31 such as an electrostatic chuck in the vacuum processing chamber. At that time, since the protrusions 6 are provided, the foreign matter attraction unit 4 and the wafer mounting table are separated from each other by a distance d, and there is no risk of the foreign matter being caught therebetween and crushed or of the surface of the attraction unit 4 or the wafer mounting table being damaged by the foreign matter.

Further, Fig. 3 illustrates a usage mode based on a modified example of the cleaning device. That is, as shown in Fig. 3, the foreign matter attraction unit 4 may be provided toward the processing space side in the vacuum processing chamber opposite to the wafer mounting table 31 to remove the foreign matter.

Here, the first example of the attraction control circuit forming the attraction control unit 5 is shown in Figs. 4 to 8. As shown in Fig. 4, the attraction control circuit according to the first example includes input terminals 7a and 7b that are connection terminals for connection with an external power supply (not shown), a capacitor 9 that is charged by the voltage of the external power supply and stores electric charges, and discharge switches 10a and 10b that discharge the electric charge stored in the capacitor 9 to charge the attraction electrodes 3 (3a and 3b). Further, diodes 11a and 11b are provided between the input terminal 7a and the capacitor 9 and between the input terminal 7b and the capacitor 9, respectively. As a result, even when the pressure in the vacuum processing chamber passes through the easy discharge region, no electric current flows from the capacitor 9 toward the input terminals 7a and 7b, and the capacitor 9 can be prevented from being charged before the attraction electrodes 3 are charged. Further, the attraction control circuit also includes a GND terminal 8 for releasing the electric charge of the charged attraction electrodes 3 (3a and 3b) and GND switches 12a and 12b for connecting the attraction electrodes 3 and the GND terminal 8.

Of these, the discharge switches 10a and 10b are remotely-operable switches (control switches) that is externally operable, and can be exemplified by timer-type switches, laser-sensing switches, and reed switches that operate with magnetic force. Among them, the discharge switches 10a and 10b in the attraction control circuit of Fig. 4 need to be of a high withstand voltage specification that can withstand a voltage of at least about 1 kV because a conduction current is energized between the capacitor 9 and the attraction electrodes 3, and since reed switches of such specification are presently readily available, such switches may be preferably used. Specific examples are commercially available products such as KSK-1A83-100150 (trade name) manufactured by Standex Electronics, Inc. Similarly, switches having high withstand voltage specifications may be likewise used for the GND switches 12a and 12b.

Then, in removing the foreign matter in the vacuum processing chamber of the semiconductor manufacturing apparatus by using the cleaning apparatus provided with the attraction control circuit of Fig. 4, first, as shown in Fig. 5, the output terminals 13a and 13b of the external power supply 13 are connected under the atmospheric pressure to the input terminals 7a and 7b, respectively, to charge the capacitor 9. At that time, it is preferable to use a high-voltage power supply as the external power supply 13, and preferably input a high voltage of about (+)1 kV to 5 kV from the V+ output terminal 13a and (-)1 kV to 5 kV from the V-output terminal 13b.

After charging the capacitor 9, the cleaning device disconnected from the external power supply 13 is moved into the closed vacuum space. Next, as shown in Fig. 6, by turning on the discharge switches 10a and 10b by an external operation, the capacitor 9 is discharged and the attraction electrodes 3 are charged. In this external operation, for example, when a reed switch is used, a magnet or the like may be attached to the outside through a glass viewport that does not interfere with magnetic force, or inside a vacuum closed space such as a vacuum processing chamber of a semiconductor manufacturing apparatus or an intermediate transfer chamber using a transfer robot. Specifically, a magnet or the like is provided at the wall surface of the intermediate transfer chamber, at the entrance of the vacuum processing chamber connecting the intermediate transfer chamber and the vacuum processing chamber, or the like, and the circuits of the discharge switches 10a and 10b may be closed when the cleaning device is arranged in the vacuum state. Further, in the case of a laser sensing type switch, a laser irradiation window may be provided in any of the vacuum closed spaces such as an intermediate transfer chamber and a vacuum processing chamber, and where a timer type switch is used, the timer may be set at the timing when the cleaning device is arranged.

Regarding the capacitor 9, where the pair of attraction electrodes 3 (3a and 3b) are considered as a capacitor, the capacitance thereof is taken as $C_{ESC}$, and the capacitance of the capacitor 9 is taken as $C_C$, the capacitance $C_c$ of the capacitor 9 may be made larger than the capacitance $C_{ESC}$ of the attraction electrodes 3, and it is preferable that the capacitance $C_C$ of the capacitor 9 be made 10 times or more the capacitance $C_{ESC}$ of the attraction electrodes 3 ($C_C \geq 10 \times C_{ESC}$). As a result, in calculation, a voltage of 90% or more of the output voltage of the external power supply 13 can be applied to the attraction electrodes 3, and after the attraction electrodes 3 (3a and 3b) are charged, it is, in particular, not necessary to keep the reed switches 10a and 10b in the turned-on state. In charging the attraction electrodes 3, the capacitance $C_C$ of the capacitor 9 may be as large as possible, and the upper limit thereof is difficult to specify, but since even if the capacitance $C_C$ of the capacitor 9 is made larger than a certain level, the amount of increase in the voltage applied to the attraction electrodes 3 is small and the effect is saturated, it can be said that it is sufficient to use a capacitor 9 having a capacitance $C_C$ of about 50 times the capacitance $C_{ESC}$.

Regarding such a relationship, where the voltage of the attraction control circuit in the state of being connected to the external power supply 13 and charging the capacitor 9 is denoted by $V_i$, the charge of the capacitor 9 is denoted by $Q_{ci}$, the capacitance of the capacitor 9 is denoted by $C_C$, the capacitance of the attraction electrodes 3 is denoted by $C_C$, as shown in Fig. 7(a), and the voltage of the attraction control circuit in the state where the external power supply 13 is disconnected, the capacitor 9 and the attraction electrodes 3 are connected and the attraction electrodes 3 are charged is denoted by $V_f$, the charge of the capacitor 9 is denoted by $Q_{cf}$, and the charge of the attraction electrodes 3 is denoted by $Q_{ESC}$, as shown in Fig. 7(b), these can be expressed as follows. That is, since the total amount of electric charge does not change before and after the connection between the capacitor 9 and the attraction electrodes 3, the following equation (1) holds.

$$Q_{ci} = Q_{cf} + Q_{ESC} \ldots (1)$$

Further, by rewriting the equation (1) using the capacitance relational expression Q = CV, the following equations (2) and (3) can be obtained.

$$C_C V_i = C_C V_f + C_{ESC} V_f \ldots (2)$$

$$V_f = [C_C/(C_C + C_{ESC})]V_i \ldots (3)$$

Here, assuming that the capacitor 9 having the capacitance $C_C$ that is 10 times the capacitance $C_{ESC}$ of the attraction electrodes 3 is used, in the calculation based on the above equation (3), it is understood that the voltage applied to the attraction electrodes 3 is about 0.91 times the voltage of the external power supply 13, as shown in the following equation (4).

$$V_f = [10C_{ESC}/(10C_{ESC} + C_{ESC})]V_i = (10/11)V_i = 0.91V_i \ ... \ (4)$$

Meanwhile, when the surface potential of the attraction electrodes 3 in the case of actually using the capacitor 9 having a capacitance $C_C$ that is about 11 times the capacitance $C_{ESC}$ of the attraction electrodes 3 and discharging from the capacitor 9 to the attraction electrodes 3 was investigated, this surface potential was confirmed to be about 0.7 times the surface potential of the attraction electrodes 3 when the attraction electrodes 3 were connected to the external power supply 13 directly, rather than through the capacitor 9. Regarding the decrease in surface potential in the case of connection through the capacitor 9, it is conceivable that the reason may be charge leakage or loss due to resistance, but based on the calculation result in (4) above, it can be said that the attraction electrodes 3 can be charged, as expected, by the discharge from the capacitor 9.

After attracting the foreign matter by charging the attraction electrodes 3 and arranging the cleaning device that expresses an electrostatic clamping force on the surface of the insulator forming the foreign matter attraction unit 4 in the vacuum processing chamber of the semiconductor manufacturing apparatus, the cleaning device with the attracted foreign matter is taken to the outside of the vacuum processing chamber. Then, as shown in Fig. 8, the GND terminal 8 is grounded to GND (ground), and the GND switches 12a and 12b and the reed switches 10a and 10b are turned on, respectively, so that the charge charged on the attraction electrodes 3 is released, the electrostatic clamping force is canceled, and the foreign matter attracted on the foreign matter attraction unit 4 is removed. At that time, the electrostatic clamping force of the cleaning device may be canceled under vacuum such as in the intermediate transfer chamber, or the electrostatic clamping force of the cleaning device may be canceled under the atmospheric pressure. The cleaning device from which the foreign matter has been removed can, of course, be used again for removing the foreign matter in the vacuum processing chamber.

Further, the attraction control circuit forming the attraction control unit 5 can be configured as in the second example shown in Fig. 9. The attraction control circuit according to the second example is different from the first example in that the discharge switch connecting the capacitor 9 and the attraction electrodes 3 is formed by a switching circuit. That is, in this second example, the discharge switch for discharging the charge stored in the capacitor 9 to charge the attraction electrodes 3 is configured of a switching circuit having solid-state relays 14a and 14b, batteries 15a and 15b that operate the solid-state relays 14a and 14b, and switches 16a and 16b that connect the batteries and the solid-state relays, and among them, for example, remotely-operable switches that is externally operable, such as timer type switches, laser-sensitive switches, and magnetically operated reed switches can be used as the circuit switches 16a and 16b.

Here, since the solid-state relays 14a and 14b are non-contact relays without a movable contact part, they can be turned on/off electronically by the action of an electronic circuit. That is, since a conduction current between the capacitor 9 and the attraction electrodes 3 is energized in the solid-state relays 14a and 14b, the configuration having high withstand voltage specifications as described in the first example may be used, the remotely-operable circuit switches 16a and 16b that is externally operable do not need to have high withstand voltage, and general-purpose switches can be used. Specific examples of such a solid-state relay include commercially available products such as AQV258A (trade name) manufactured by Panasonic Corporation.

The attraction control circuit according to this second example is the same as that of the first example except that the discharge switch is configured of the switching circuit. That is, charging of the capacitor 9 under the atmospheric pressure by connecting to an external power supply, charging of the attraction electrodes 3 by discharging the capacitor 9 in the closed vacuum space, and canceling the electrostatic clamping force after the foreign matter in the vacuum processing chamber has been attracted can be performed in the same manner as described in the first example.

Further, the attraction control circuit forming the attraction control unit 5 can also be configured as in the third example shown in Fig. 10. This third example differs from the above-described first and second examples in that the attraction control unit incorporates a power supply for developing an electrostatic clamping force. That is, the attraction control circuit according to the third example includes a booster circuit 17 that boosts the voltage, a battery 18 for operating the booster circuit 17, and a voltage application switch 19 for charging the attraction electrodes 3 by a high voltage output from the booster circuit 17.

Here, as the voltage application switch 19, a remotely-operable switch (control switch) that can be externally operated is used, and examples thereof include a timer type switch, a laser sensing type switch, and a reed switch that is operated by magnetic force, the reed switch being preferable. However, in this case, since the switch is for connecting the battery 18 and the booster circuit 17, it is not particularly necessary to use a switch having a high withstand voltage specification. Further, the booster circuit 17 that may output a high voltage of about (+)1 kV to 5 kV from a V+ output terminal 17a and about (-)1 kV to 5 kV from a V- output terminal 17b may be used to charge the attraction electrodes 3 and exhibit an electrostatic clamping force. Such a booster circuit 17 is not particularly limited, and a known one such as a Cockcroft-Walton circuit or the like can be used.

When removing foreign matter in a vacuum processing chamber of a semiconductor manufacturing apparatus by using a cleaning device equipped with an attraction control circuit with a built-in power supply such as shown in Fig.

10, the cleaning device is arranged in a vacuum closed space such as an intermediate transfer chamber, a vacuum processing chamber, or the like, and the voltage application switch 19 is turned on in a vacuum state. As a result, an electrostatic clamping force is generated on the surface of the insulator forming the foreign matter attraction unit 4, so that a cleaning device is arranged in the vacuum processing chamber of the semiconductor manufacturing apparatus to attract foreign matter. After the foreign matter has been attracted in the vacuum processing chamber, the cleaning device with the attracted foreign matter is taken out of the vacuum processing chamber, and the voltage application switch 19 is turned off to cancel the electrostatic clamping force and remove the foreign matter from the attraction unit 4. The voltage application switch 19 may be turned off in a vacuum state or an atmospheric pressure state.

Further, the attraction control circuit forming the attraction control unit 5 can be configured as in the fourth example shown in Fig. 11. In this fourth example, the attraction control unit has a built-in power supply as in the third example above, but the difference with the third example is that diodes 20a and 20b are provided between the booster circuit 17 and the attraction electrodes 3, and a GND terminal 21 for releasing the electric charge of the charged attraction electrodes 3 and GND switches 22a and 22b for connecting the attraction electrodes 3 and the GND terminal 21 are provided. That is, since the diodes 20a and 20b are provided, the charging of the attraction electrodes 3 by the high voltage output from the booster circuit 17 is maintained by a rectifying action. Therefore, after charging the attraction electrodes 3, it is not necessary to continuously maintain the voltage application switch 19 in the turned-on state. Further, by providing the GND terminal 21, after the attraction of foreign matter in the vacuum processing chamber is completed, the GND switches 22a and 22b are turned on, thereby making it possible to release the charge charged to the attraction electrodes 3, cancel the electrostatic clamping force, and remove the foreign matter attracted on the foreign matter attraction unit 4. Other features are the same as in the third example.

Examples

(Test Example 1)

In order to compare the electrostatic clamping force demonstrated in the vacuum processing chamber, a test was conducted in the following manner to measure the electrostatic clamping force when the attraction electrodes are charged under the atmospheric pressure and the electrostatic clamping force when the attraction electrodes are charged under vacuum. Fig. 12 shows a test apparatus used in this test. Here, a test cleaning device was arranged in a vacuum chamber 23 connected to a rotary pump (not shown), and a load cell 25 to which a silicon wafer 24 cut out to a size of 50 mm $\times$ 48 mm (24 cm$^2$) was attached was provided above the test cleaning apparatus. The test cleaning device was equipped with a foreign matter attraction unit 4 on the upper surface of an about 120 mm $\times$ 120 mm aluminum base (base portion) 1 having a thickness of about 5 mm, and a double-sided tape 26 was attached to the lower surface of the aluminum base 1 on the opposite side to fix the foreign matter attraction unit to the inner wall bottom surface of a vacuum chamber 23. Regarding the silicon wafer 24, in order to prevent damage (to prevent contamination in the vacuum chamber due to cracking or chipping of the wafer), a polyimide protective film was attached to the side opposite to the surface facing the test cleaning device.

In preparing the test cleaning device, first, a polyimide film having a thickness of 50 $\mu$m and laminated with a copper foil having a thickness of about 10 $\mu$m was prepared, and the copper foil portion was etched to obtain attraction electrodes in which two angular electrodes of about 58 mm $\times$ 110 mm faced each other. Next, using a bonding sheet having a thickness of about 10 $\mu$m, the polyimide film after copper foil etching and the polyimide film having a thickness of 50 $\mu$m were bonded together, and then cut out to a size of about 120 mm $\times$ 120 mm along the outer periphery of the attraction electrodes 3. As a result, a foreign matter attraction unit 4 having the attraction electrodes inside an insulator made of two polyimide films was produced. Further, silicone cables 27a and 27b were respectively connected to the pair of angular electrodes 3a and 3b forming the attraction electrodes 3 of the foreign matter attraction unit 4, the tips of the cables were pulled out to the outside of the vacuum chamber 23, and reed switches 28a and 28b (KSK-1A83-100150 (trade name) manufactured by Standex Electronics, Inc.) were connected to respective cables. These silicone cables 27a and 27b were passed through a cylindrical metal part (not shown), the metal part was fitted into a vacuum chamber, and a gap was sealed with an O-ring.

Regarding the case of charging the attraction electrodes under the atmospheric pressure by using the test device prepared as described above, first, (1) the reed switches 28a and 28b of the test cleaning device were connected to the GND in advance and turned on, the charge on the attraction electrodes 3 was removed (reset), and then the reed switches 28a and 28b were turned off again. Next, (2) a high-voltage power supply (not shown) was connected to the input terminals of the reed switches 28a and 28b, the reed switches 28a and 28b were turned on, and DC $\pm 400$ V was applied to the attraction electrodes 3 (3a and 3b) and maintained for 10 seconds (the reed switches were turned on for 10 seconds). Next, (3) the reed switches 28a and 28b were turned off (after the voltage application was completed), the switch of the high-voltage power supply was turned off, and thereafter the reed switches 28a and 28b and the high-voltage power supply were disconnected (this was done so because where the high-voltage power supply is turned off while the reed switch is turned on, the charge is removed, and also because where the reed switch is turned off and then disconnected while the power supply is on, the charge remains on the reed switch side connected to the power supply). Then, (4) 2 minutes after the reed switches 28a and 28b were turned off, a rotary pump (not shown) was operated to start evacuation. About 3 minutes later, the pressure in the vacuum chamber 23 was reduced to about 40 Pa to 50 Pa. Then, (5) 5 minutes after the reed switches 28a and 28b were turned off, a load cell 25 was lowered and a silicon wafer 24 was placed on the foreign matter attraction unit 4 of the test cleaning device. Next, (6) 5 minutes and 30 seconds after the reed switches 28a and 28b were turned off, the load cell 25 was raised to pull up the silicon wafer 24, and the attraction force was measured.

Regarding the case of charging the attraction electrodes under vacuum, the inside of the chamber 23 was first evacuated, and then the attraction force was measured in the same manner as above. That is, first, (4) the rotary pump was operated to reduce the pressure in the vacuum chamber 23 to about 40 Pa, then (1) the reed switches 28a and 28b were connected to the GND and the switches were turned on to remove the charge of the attraction electrodes 3, the reed switches 28a and 28b were then turned off again, (2) a high-voltage power supply (not shown) was connected to the input terminal side of the reed switches 28a and 28b to turn on the reed switches 28a and 28b, and DC ±400 V was applied to the attraction electrodes 3 (3a, 3b) and maintained for 10 seconds. Next, (3) after turning off the reed switches 28a and 28b, the switch of the high-voltage power supply was turned off, and then the reed switches 28a and 28b and the high-voltage power supply were disconnected. Then, (5) 5 minutes after the reed switches 28a and 28b were turned off, the load cell 25 was lowered to place the silicon wafer 24 on the foreign matter attraction unit 4 of the test cleaning device. Next, (6) 5 minutes and 30 seconds after the reed switches 28a and 28b were turned off, the load cell 25 was raised to pull up the silicon wafer 24, and the attraction force was measured.

Fig. 13 shows the outline of measurement conditions and pressure conditions for comparing the electrostatic clamping force generated under the atmospheric pressure and the electrostatic clamping force generated under vacuum. Further, Fig. 14 shows the measurement results. The attraction force is measured twice under the atmospheric pressure and under vacuum, and Fig. 14 shows the clamping force per unit area of the silicon wafer (Si wafer) as an average value. As can be seen from this graph, the electrostatic clamping force generated under vacuum showed far superior results (6 to 7 times) compared to the electrostatic clamping force generated under the atmospheric pressure. Incidentally, the value obtained by measuring the clamping force without connecting to the high-voltage power supply in (2), among the procedures for charging the attraction electrodes under vacuum, is also shown in Fig. 14.

(Test Example 2)

In order to compare the surface potential when the attraction electrodes are charged between the case of the atmospheric pressure maintenance condition of maintaining at atmospheric pressure and the case of the via-vacuum condition of changing from atmospheric pressure to vacuum and the returning to atmospheric pressure, the following test was conducted to measure the surface potential. Since the surface potential could not be measured under vacuum due to the specifications of the surface potential measuring device (KSD-3000 manufactured by Kasuga Electric Works Ltd.) used, the above conditions were adopted herein.

Fig. 15 shows the test equipment used in this test. First, the test cleaning device was equipped with a foreign matter attraction unit 4 on the lower surface side of an about 120 mm × 120 mm aluminum base (base portion) 1 having a thickness of about 5 mm; the foreign matter attraction unit 4 was produced in the same manner as in Test Example 1. Further, the silicone cables 27a and 27b were connected to the pair of angular electrodes 3a and 3b forming the attraction electrodes 3 of the foreign matter attraction unit 4, respectively, and reed switches (KSK-1A83-100150 (trade name) manufactured by Standex Electronics, Inc.) 28a and 28b were connected to the tips of the silicone cables in the same manner as in Test Example 1, but in this Test Example 2, since the reed switches 28a and 28b are also included in the vacuum chamber 23, as will be described hereinbelow, the solder and the exposed lead wire of the portion where the silicone cables 27a and 27b and the reed switches 28a and 28b were connected to each other was subjected to insulation treatment 29 by potting with an EVA resin. Further, an aluminum spacer (protrusion) 30 was provided around the lower surface side of the aluminum base 1, and when the test cleaning device was installed in the vacuum chamber 23, a distance d of about 5 mm was provided between the bottom surface of the inner wall of the vacuum chamber 23 and the foreign matter attraction unit 4.

Using the cleaning device according to Test Example 2 prepared as described above, the surface potential when the attraction electrodes were charged was measured as follows.

First, in the case where the cleaning device was maintained under the atmospheric pressure from beginning to end, (1) a high-voltage power supply (not shown) was connected to the input terminal side of the reed switches 28a and 28b, the reed switches 28a and 28b were turned on to apply DC ±3.5 kV to the attraction electrodes 3 (3a and 3b), and the surface potential of the foreign matter attraction unit 4 was measured in the state where this voltage was applied [measurement (i)]. Next, (2) the reed switches 28a and 28b were turned off, the high-voltage power supply was turned off, the high-voltage power supply was disconnected from the reed switches 28a and 28b, and the surface potential of the foreign matter attraction unit 4 was measured immediately after the reed switches were turned off [measurement (ii)]. Next, (3) this test cleaning device was placed in a vacuum chamber 23 connected to a rotary pump (not shown), and allowed to stand for 5 minutes in an atmospheric pressure state. Finally, (4) the test cleaning device was taken out from the vacuum chamber 23, and the surface potential of the foreign matter attraction unit 4 was measured at a timing of 10 minutes after the reed switches 28a and 28b were turned off in (2) [measurement (iii)].

Meanwhile, in the case where the cleaning device in the atmospheric pressure state was once evacuated and then returned to the atmospheric pressure, the steps (1) to (4) above were implemented in the same manner except that the test cleaning device was put in the vacuum chamber 23 and the rotary pump was operated for 5 minutes in the above (3). That is, (1) a high-voltage power supply was connected, and the surface potential of the foreign matter attraction unit 4 was measured after applying DC $\pm 3.5$ kV to the attraction electrodes 3 (3a and 3b) [measurement (i)]. Next, (2) the surface potential of the foreign matter attraction unit 4 immediately after the reed switches 28a and 28b were turned off was measured [measurement (ii)], and then (3) the test cleaning device was put in the vacuum chamber 23, the rotary pump was operated, the pressure was reduced for 5 minutes, and after the pressure inside the vacuum chamber 23 reached a vacuum of about 40 Pa, (4) the inside of the vacuum chamber 23 was returned to the atmospheric pressure again, the test cleaning device was removed from the vacuum chamber 23, and the surface potential of the foreign matter attraction unit 4 was measured at a timing of 10 minutes after the reed switches 28a and 28b were turned off in (2) [measurement (iii)].

Fig. 16 shows an outline of measurement conditions and pressure conditions for comparing surface potentials when the pressure environment is changed. Further, Figs. 17 and 18 show the measurement results. Of these, Fig. 17 shows the measurement results of the surface potential under the atmospheric pressure maintenance condition in which the cleaning device was maintained at the atmospheric pressure from beginning to end, and all of them showed almost the same surface potential. In particular, 10 minutes after the reed switch was turned off, the surface potential showed a high value corresponding to about 92% that in the voltage-applied state. Meanwhile, Fig. 18 shows the result obtained under a via-vacuum condition, and 10 minutes after the reed switch was turned off, the surface potential decreased to a value corresponding to about 14% that in the voltage-applied state.

There are two causes of the surface potential decrease such as shown in Fig. 18, one is due to the environmental change from the atmospheric pressure to vacuum and the other is due to the environmental change from vacuum to the atmospheric pressure. Considering the results of Test Example 1 hereinabove, it is conceivable that the surface potential is decreased at least in the case of the environmental change from the atmospheric pressure to vacuum. In other words, as can be seen from these test examples, the electrostatic clamping force obtained by charging under the atmospheric pressure is dramatically reduced by the transition into a vacuum state (the reason for this is presently not sufficiently clear). The surface potential in Test Example 2 represents the difference in surface potential between the pair of angular electrodes 3a and 3b in the attraction electrode.

[Reference Signs List]

1    Base portion
2    Polyimide film
3    Attraction electrode
4    Foreign matter attraction unit
5    Attraction control unit
6    Protrusion
7    Input terminal (connection terminal)
8    GND terminal
9    Capacitor
10   Discharge switch
11   Diode
12   GND switch
13   External power supply
14   Solid-state relay
15   Battery
16   Circuit switch
17   Booster circuit
18   Battery
19   Voltage application switch
20   Diode

21    GND terminal
22    GND switch
23    Vacuum chamber
24    Silicon wafer
25    Load cell
26    Double-sided tape
27    Silicone cable
28    Reed switch
29    Insulation treatment
30    Spacer
31    Wafer mounting table


**Claims**

1.  A cleaning device for removing foreign matter in a vacuum processing chamber of a semiconductor manufacturing apparatus, the cleaning device comprising:

    a foreign matter attraction unit in which attraction electrodes composed of a pair of electrodes are provided inside an insulator; and an attraction control unit that turns on a control switch to charge the attraction electrodes and generate an electrostatic clamping force on a surface of the insulator to enable attraction of foreign matter, wherein
    the control switch of the attraction control unit is a remotely-operable switch that is externally operable, and foreign matter in the vacuum processing chamber is removed by an electrostatic clamping force generated in a vacuum state by turning on the control switch for the cleaning device in a vacuum closed space closed in the vacuum state.

2.  The cleaning device according to claim 1, wherein
    the attraction control unit includes a connection terminal for connection with an external power supply, a capacitor that is charged by a voltage of the external power supply and that stores an electric charge, and a discharge switch that discharges the charge stored in the capacitor to charge the attraction electrodes, and the control switch is configured by the discharge switch; and
    when the capacitor is charged by connection of the external power supply to the connection terminal under the atmospheric pressure and then the cleaning device is placed in a vacuum closed space and the discharge switch is turned on, an electrostatic clamping force is generated in a vacuum state.

3.  The cleaning device according to claim 2, wherein the discharge switch is a reed switch operated by a magnetic force, and a conduction current between a capacitor and the attraction electrodes is energized in the reed switch.

4.  The cleaning device according to claim 2, wherein the discharge switch is configured of a switching circuit including a solid-state relay, a battery that operates the solid-state relay, and a circuit switch connecting the solid-state relate and the battery, and the circuit switch is any remotely-operable switch selected from the group consisting of a timer type switch, a laser sensing type switch, and a reed switch operated by a magnetic force.

5.  The cleaning device according to claim 1, wherein the attraction control unit includes a booster circuit that boosts a voltage, a battery that operates the booster circuit, and a voltage application switch for charging the attraction electrodes by a high voltage output from the booster circuit, the voltage application switch constituting the control switch, and
    an electrostatic clamping force is generated in a vacuum state by arranging the cleaning device in a closed vacuum space and turning on the voltage application switch.

6.  The cleaning device according to claim 5, wherein the voltage application switch is any remotely-operable switch selected from the group consisting of a switch with a timer , a laser-sensing switch, and a reed switch that is operated by a magnetic force.

7.  The cleaning device according to claim 5 or 6, wherein the attraction control unit has a diode between the booster circuit and the attraction electrodes, and charging of the attraction electrodes by a high voltage output from the booster circuit is maintained by a rectifying action.

8. The cleaning device according to any one of claims 1 to 7, wherein the attraction control unit includes a GND terminal for releasing an electric charge of the charged attraction electrodes, and a GND switch that connects between the attraction electrodes and the GND terminal, and after foreign matter in the vacuum processing chamber has been attracted, the foreign matter is removed from the surface of the insulator of the foreign matter attraction unit by turning on the GND switch.

9. The cleaning device according to any one of claims 1 to 8, wherein the foreign matter attraction unit and the attraction control unit are integrally provided on one surface of a base portion, and the insulator of the foreign matter attraction unit is arranged so as to face a wafer mounting table in the vacuum processing chamber to remove foreign matter on the wafer mounting table.

10. The cleaning device according to claim 9, further comprising a protrusion for separating a surface of the insulator in the foreign matter attraction unit and the wafer mounting table from each other.

11. The cleaning device according to claim 10, wherein the surface of the insulator in the foreign matter attraction unit includes an adhesive layer having adhesiveness.

EP 3 846 198 A1

Fig. 1 (a)

Fig. 1 (b)

Fig. 1(c)

Fig. 2

Fig. 3

Fig. 4

Fig. 5

Fig. 6

Fig. 7 (a)

Fig. 7 (b)

Fig. 8

Fig. 9

Fig. 10

Fig. 11

Fig. 12

ATMOSPHERIC PRESSURE

ATMOSPHERE→VACUUM

VACUUM

0 MINUTES
(REED SWITCH OFF)

2 MINUTES

VACUUM IS MAINTAINED

5 MINUTES

5 MINUTES 30 SECONDS

WAFER IS LOWERED    WAFER IS PULLED UP

Fig. 13

AVERAGE CLAMPING FORCE OF Si WAFER

Fig. 14

Fig. 15(a)

Fig. 15(b)

ATMOSPHERIC PRESSURE
MAINTENANCE CONDITION

ATMOSPHERIC
PRESSURE

VIA-VACUUM CONDITION

VACUUM

0 MINUTES
(REED SWITCH OFF)

4 MINUTES

9 MINUTES | 10 MINUTES

MEASUREMENT MEASUREMENT
(i)              (ii)

CLEANING DEVICE IS IN CHAMBER

MEASUREMENT
(iii)

Fig. 16

DIFFERENCE IN SURFACE POTENTIAL
BETWEEN + SIDE AND – SIDE
ATMOSPHERIC PRESSURE CONDITION

Fig. 17

DIFFERENCE IN SURFACE POTENTIAL
BETWEEN + SIDE AND - SIDE
VIA-VACUUM CONDITION

Fig. 18

## INTERNATIONAL SEARCH REPORT

| | International application No. |
|---|---|
| | PCT/JP2019/033077 |

**A. CLASSIFICATION OF SUBJECT MATTER**
Int.Cl. H01L21/02(2006.01)i, H01L21/677(2006.01)i

According to International Patent Classification (IPC) or to both national classification and IPC

**B. FIELDS SEARCHED**

Minimum documentation searched (classification system followed by classification symbols)
Int.Cl. H01L21/02, H01L21/677

Documentation searched other than minimum documentation to the extent that such documents are included in the fields searched
    Published examined utility model applications of Japan    1922–1996
    Published unexamined utility model applications of Japan    1971–2019
    Registered utility model specifications of Japan    1996–2019
    Published registered utility model applications of Japan    1994–2019

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 11-87457 A (HITACHI, LTD.) 30 March 1999, paragraphs [0013]-[0023], fig. 1-3 (Family: none) | 1<br>2-11 |
| A | JP 2009-239013 A (TOKYO ELECTRON LTD.) 15 October 2009, paragraphs [0046]-[0053], [0061]-[0073], fig. 1-4<br>& US 2009/0241992 A1, paragraphs [0061]-[0068], [0076]-[0088], fig. 1-4 | 2-11 |

☐   Further documents are listed in the continuation of Box C.      ☐   See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27.09.2019 | 08.10.2019 |

| Name and mailing address of the ISA/<br>  Japan Patent Office<br>  3-4-3, Kasumigaseki, Chiyoda-ku,<br>  Tokyo 100-8915, Japan | Authorized officer<br><br><br>Telephone No. |
|---|---|

Form PCT/ISA/210 (second sheet) (January 2015)

**EP 3 846 198 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000260671 A
- JP 2002028594 A
- JP 5956637 B